# EUROPÄISCHE PATENTSCHRIFT

(11) **EP 3 154 077 B1**
(45) Veröffentlichungstag und Bekanntmachung des Hinweises auf die Patenterteilung: **28.04.2021**
(21) Anmeldenummer: 16191719.0
(22) Anmeldetag: 30.09.2016
(51) Int. Cl.: H01L 21/48, H01L 23/538

(54) **VERFAHREN ZUM HERSTELLEN EINES ELEKTRONISCHEN BAUELEMENTS UND ELEKTRONISCHES BAUELEMENT**
METHOD FOR MANUFACTURING AN ELECTRONIC ELEMENT AND AN ELECTRONIC ELEMENT
PROCÉDÉ DE FABRICATION D'UN COMPOSANT ÉLECTRONIQUE ET COMPOSANT ÉLECTRONIQUE

(30) Priorität: 05.10.2015 DE 102015219190
(43) Veröffentlichungstag der Anmeldung: 12.04.2017
(73) Patentinhaber: Fraunhofer-Gesellschaft zur Förderung der angewandten Forschung e.V., 80686 München (DE)
(72) Erfinder: Dr. Braun, Tanja, 14052 Berlin (DE); Becker, Karl-Friedrich, 10999 Berlin (DE); Kahle, Ruben, 13409 Berlin (DE); Dr. Töpper, Michael, 13507 Berlin (DE)
(74) Vertreter: Pfenning, Meinig & Partner mbB

(56) Entgegenhaltungen:
- EP-A2- 2 071 618
- FR-A1- 2 917 895
- US-A1- 2004 147 064
- US-A1- 2005 026 328

## Beschreibung

Die Erfindung betrifft ein Verfahren zum Herstellen eines elektronischen Bauelements gemäß dem Oberbegriff des Anspruchs 1. Außerdem betrifft die Erfindung ein elektronisches Bauelement.

Ein bekanntes Verfahren zum Herstellen eines gehäusten elektronischen Bauelements ist beispielsweise in der Druckschrift DE 197 47 177 C2 beschrieben. Hierbei wird ein Leiterbahnen aufweisendes Substrat mit einem flexiblen Bereich so durch Verbiegen des flexiblen Bereichs geklappt, dass verschiedene mit Bauelementen bestückte Bereiche des Substrats übereinander angeordnet werden. Ein auf diese Weise hergestelltes Bauelement zeichnet sich durch einen geringen Platzbedarf gegenüber Gehäuseformen aus, die auf einem ebenen (zweidimensionalen) Aufbau von Schaltungen basieren. Ein elektronisches Bauelement verwandter Art ist beispielsweise aus der Druckschrift EP 2 071 618 A2 bekannt. Hierbei wird ein Paket mit integrierten Schaltkreisen dadurch hergestellt, dass eine flexible dielektrische Membran auf einen Halbleiterwafer aufgebracht wird. Anschließend wird der Halbleiterwafer vereinzelt, wobei die Membran als Biegestelle zwischen unterschiedlichen Bereichen des Halbleiterwafers verbleibt. Ein weiteres Verfahren verwandter Art ist in der Druckschrift US 2005/026328 A1 beschrieben. Zudem gehören die Druckschriften FR 2 917 895 A1 und US 2004/147064 A1 auf dem Gebiet der vorliegenden Anmeldung zum Stand der Technik.

Aufgabe der vorliegenden Erfindung ist es, ein Verfahren zum Herstellen eines elektronischen Bauelements, welches sich variabel an unterschiedliche Anwendungsgeometrien anpassen lässt, vorzuschlagen. Insbesondere ist es eine Aufgabe der vorliegenden Erfindung, ein vereinfachtes Verfahren zum Herstellen eines elektronischen Bauelements mit einem geringen Flächenbedarf vorzuschlagen.

Gelöst wird diese Aufgabe durch ein Verfahren mit den Merkmalen des Hauptanspruchs. Vorteilhafte Weiterbildungen ergeben sich mit den Merkmalen der abhängigen Ansprüche und der Ausführungsbeispiele.

Bei dem vorgeschlagenen Verfahren zum Herstellen eines elektronischen Bauelements wird eine Halbleiteranordnung umfassend eine Trägerstruktur und eine Umverdrahtungslage bereitgestellt. Die Trägerstruktur weist mindestens einen in eine Vergussmasse eingebundenen Halbleiterchip auf. Die Umverdrahtungslage weist biegbares Material und mindestens eine Leiterbahn auf, wobei die Trägerstruktur zumindest bereichsweise mit der Umverdrahtungslage verbunden ist und der mindestens eine Halbleiterchip mit der Umverdrahtungslage elektrisch leitfähig verbunden ist. Anschließend wird die Trägerstruktur entlang mindestens eines Trenngrabens getrennt, derart, dass die Trägerstruktur in mindestens zwei vereinzelte Trägerelemente aufgeteilt wird, wobei zwei benachbarte der vereinzelten Trägerelemente über den jeweiligen Trenngraben durch die Umverdrahtungslage miteinander verbunden sind.

Ein gemäß dem vorgeschlagenen Verfahren hergestelltes Bauelement ist im Bereich eines Trenngrabens biegbar. Es kann beispielsweise vorgesehen sein, dass die Umverdrahtungslage nach dem Trennen im Bereich eines Trenngrabens um einen vorgegebenen Winkel gebogen wird. Diese Ausführung erlaubt eine dreidimensionale Anordnung der Halbleiterchips, so dass beispielsweise elektronische Bauelemente mit einem geringen Flächenbedarf gefertigt werden können oder dass elektronische Bauelemente gefertigt werden können, die sich für eine Anbringung des Bauelementes an einer dafür vorgesehenen, gekrümmten Fläche eignen.

Vorteilhafterweise können durch das vorgeschlagene Verfahren wesentliche Herstellungsschritte, wie beispielsweise eine Herstellung von Leiterbahnen und elektrischen Kontakten zu den Halbleiterchips, durchgeführt werden, während die Halbleiterchips nebeneinander angeordnet sind. Erst durch den Schritt des Biegens wird eine dreidimensionale Anordnung der Halbleiterchips erreicht. Dies erlaubt beispielsweise eine vereinfachte Herstellung von dreidimensionalen elektronischen Bauelementen.

Ein vorgegebener Winkel kann beispielsweise derart gewählt werden, dass zwei benachbarte der vereinzelten Trägerelemente nach dem Biegen an dem Bereich der Umverdrahtungslage, welcher zwischen den beiden benachbarten Trägerelementen angeordnet ist, einen Winkel von mehr als 2 Grad, vorzugweise mehr als 5 Grad, besonders bevorzugt mehr als 10 Grad, aufweisen.

Durch die Leiterbahnen der Umverdrahtungslage kann ein elektrisch leitfähiger Kontakt zwischen verschiedenen Bereichen des mindestens einen Halbleiterchips oder zwischen dem mindestens einen Halbleiterchip und gegebenenfalls auf der Umverdrahtungslage vorgesehenen Anschlussstellen zur Verbindung des Halbleiterchips mit weiteren Bauelementen hergestellt werden. Die Anschlussstellen, wie beispielsweise Kontakt-Pads, Lötkontakte oder Steckerkontakte, können hierbei über eine Fläche der Umverdrahtungslage verteilt sein, die deutlich größer ist als eine Fläche des Halbleiterchips. Wenn das elektronische Bauelement mehrere Halbleiterchips umfasst, können die Leiterbahnen einer Herstellung einer elektrisch leitfähigen Verbindung der Halbleiterchips untereinander dienen.

Das elektronische Bauelement kann beispielsweise mindestens zwei, mindestens drei oder mindestens vier Halbleiterchips umfassen. Beispielsweise kann das elektronische Bauelement zehn Halbleiterchips umfassen. Es kann vorgesehen sein, dass jedes der vereinzelten Trägerelemente genau einen Halbleiterchip umfasst. Alternativ kann es vorgesehen sein, dass einige oder sämtliche der vereinzelten Trägerelemente mehr als einen Halbleiterchip umfassen. Es kann auch vorgesehen sein, dass mindestens eines der vereinzelten Trägerelemente keinen Halbleiterchip aufweist. Es ist auch möglich, dass das elektronische Bauelement zusätzlich zu dem mindestens einen Halbleiterchip weitere elektronische Komponenten, beispielsweise anwendungsspezifische integrierte Schaltungen, Sensoren oder passive Komponenten wie Kondensatoren, Widerstände, Spulen oder Antennen, umfasst, die mit der Umverdrahtungslage elektrisch leitfähig verbunden sind. Diese weiteren elektronischen Komponenten können auch in die Trägerstruktur bzw. die vereinzelten Trägerelemente eingebettet sein.

Zumindest einige der Leiterbahnen sind biegbar ausgeführt, so dass eine durch die Leiterbahnen hergestellte elektrische Verbindung im Bereich des Trenngrabens durch ein Biegen der Umverdrahtungslage in diesem Bereich nicht unterbrochen wird. Die Leiterbahnen können beispielsweise Metalle oder elektrisch leitfähige Polymere umfassen.

Die Trägerstruktur kann als Teil eines künstlichen oder rekonfigurierten Wafers ausgeführt sein. Der künstliche Wafer kann eine im Wesentlichen rechteckige Paneelform oder eine im Wesentlichen runde Waferform aufweisen. Typischerweise werden bei der Herstellung des elektronischen Bauelements Schnitte durchgeführt, bei denen die Trägerstruktur und die Umverdrahtungslage durchtrennt werden. Auf diese Weise können aus einem rekonfigurierten Wafer Bereiche herausgetrennt werden, aus denen das elektronische Bauelement mit dem vorgeschlagenen Verfahren hergestellt wird.

Die Trenngräben können im Wesentlichen bis zur Umverdrahtungslage reichen. Insbesondere kann es vorgesehen sein, dass die Trenngräben teilweise in die Umverdrahtungslage hineinreichen. Das Trennen kann beispielsweise mittels Sägen, Lasern, Fräsen oder Wasserstrahlschneiden erfolgen. Die Trenngräben können an einer breitesten Stelle eine Breite zwischen 25 und 500 µm, bevorzugt zwischen 100 und 200 µm, aufweisen

Es kann vorgesehen sein, dass das biegbare Material ein biegbares Polymer umfasst. Beispielsweise kann das biegbare Material Silikon, Polyimid, Epoxidharz oder Polyurethan umfassen. Typischerweise ist das biegbare Material ein elektrisch isolierendes Material.

Es kann vorgesehen sein, dass die Umverdrahtungslage bei der Herstellung des elektronischen Bauelements im Bereich eines Trenngrabens derart gebogen wird, dass mindestens zwei der vereinzelten Trägerelemente zumindest teilweise überlappend übereinander angeordnet werden. Durch das Überlappen der vereinzelten Trägerelemente kann eine kompakte Bauform eines elektronischen Bauelements erreicht werden, bei der das elektronische Bauelement einen geringen Flächenbedarf aufweist.

Es kann auch vorgesehen sein, dass das biegbare Material ein faltbares Material ist und dass die Umverdrahtungslage am Bereich eines Trenngrabens, derart gefaltet wird, dass mindestens zwei benachbarte der vereinzelten Trägerelemente zumindest teilweise überlappend übereinander angeordnet werden. Ein Falten ist im Sinne dieser Anmeldung als ein starkes Biegen, beziehungsweise als ein Biegen mit einem geringen Krümmungsradius und über einen großen Biegewinkel, zu verstehen. Ein Falten benachbarter vereinzelter Trägerelemente und deren Überlappen kann eine besonders kompakte Bauweise des elektronischen Bauelements erreicht werden.

Hierbei sind typischerweise zumindest einige der Leiterbahnen faltbar ausgeführt, so dass eine durch die Leiterbahnen hergestellte elektrische Verbindung im Bereich des Trenngrabens durch ein Falten der Umverdrahtungslage an diesem Bereich nicht unterbrochen wird.

Die Trägerstruktur kann entlang mehrerer Trenngräben in mehrere vereinzelte Trägerelemente getrennt werden, die über die Umverdrahtungslage miteinander verbunden sind, wobei die mehreren Trenngräben im Wesentlichen parallel verlaufen. Durch parallel verlaufende Trenngräben kann durch Biegen eine platzsparende Stapelung der vereinzelten Trägerelemente erreicht werden.

Außerdem kann vorgesehen sein, dass mindestens zwei benachbarte der Trenngräben einen Abstand aufweisen, der im Wesentlichen einem Ein- oder Vielfachen einer Höhe der Trägerstruktur und der Umverdrahtungslage entspricht. Dadurch kann eine besonders kompakte Ausführung des elektronischen Bauelements erreicht werden, bei der das zwischen den benachbarten Trenngräben angeordnete vereinzelte Trägerelement nach dem Biegen im Wesentlichen senkrecht zu den anderen vereinzelten Trägerelementen orientiert ist. Die Höhe der Trägerstruktur kann zwischen 100 und 500 µm, bevorzugt zwischen 150 und 250 µm, betragen.

In einer Ausführungsform wird bei dem Verfahren zum Herstellen eines elektronischen Bauelements ein Durchkontakt durch die Trägerstruktur hergestellt, derart, dass eine elektrisch leitfähige Verbindung zwischen der Umverdrahtungslage und einer von der Umverdrahtungslage abgewandten Seite der Trägerstruktur hergestellt wird.

Ein Durchkontakt erlaubt beispielsweise eine elektrische Verbindung zwischen der Umverdrahtungslage und gegebenenfalls auf einer der Umverdrahtungslage abgewandten Seite eines vereinzelten Trägerelements angeordneten Komponenten, wie passiven oder aktiven elektronischen Bauelementen, oder Anschlussstellen, wie Lötkontakten oder Kontakt-Pads. Beispielsweise kann eine Antenne auf einer der Umverdrahtungslage abgewandten Seite eines der vereinzelten Trägerelemente angeordnet sein.

Die Leiterbahnen der Umverdrahtungslage können auch mehrlagig ausgeführt sein, so dass sich Leiterbahnen kreuzen können, ohne dass diese elektrisch leitfähig miteinander verbunden sind. Eine solche Ausführung erlaubt zusätzliche Möglichkeiten bei der Umverteilung der elektrischen Kontakte.

In einer Ausführung ist vorgesehen, dass sich die zwei benachbarten der vereinzelten Trägerelemente beim Biegen voneinander abwenden. Eine derartige Biegung eignet sich insbesondere bei einer geringen Breite des Trenngrabens oder bei einer Höhe der Trägerstruktur, die vergleichbar mit der Breite des Trenngrabens oder größer ist. Hierdurch können Biegungen in Form von Faltungen mit einem Faltwinkel von bis zu 180 Grad erreicht werden.

Das Trennen der Trägerstruktur erfolgt durch mindestens einen in Richtung der Umverdrahtungslage verjüngten V-Schnitt. Es kann auch vorgesehen sein, dass das Trennen derart erfolgt, dass zwei benachbarte Trenngräben in Richtung der Umverdrahtungslage verjüngt sind. Diese können parallel verlaufen und einen Abstand aufweisen, der im Wesentlichen einem Zweifachen der Höhe der Trägerstruktur entspricht.

Es kann hierbei vorgesehen sein, dass sich die zwei benachbarten der vereinzelten Trägerelemente beim Biegen einander zuwenden. Insbesondere bei zwei derartigen Biegungen entlang benachbarter Trenngräben, die durch einen V-Schnitt hergestellt wurden, kann hierbei eine besonders kompakte Ausführung des elektronischen Bauelements erreicht werden.

Zum Bereitstellen der Halbleiteranordnung kann vorgesehen sein, dass zunächst mindestens ein Halbleiterchip bereitgestellt wird. Anschließend kann der mindestens eine Halbleiterchips auf einem Substrat angeordnet werden. Es kann vorgesehen sein, dass der mindestens eine Halbleiterchip vergossen wird, so dass die Trägerstruktur gebildet wird, die die Vergussmasse und den darin eingebundenen mindestens einen Halbleiterchip umfasst. Daraufhin kann die zumindest bereichsweise mit der Trägerstruktur verbundene Umverdrahtungslage hergestellt werden, die das biegbare Material und die mindestens eine Leiterbahn umfasst, derart, dass die Umverdrahtungslage den mindestens einen Halbleiterchip elektrisch kontaktiert, wobei aus der Trägerstruktur und der Umverdrahtungslage die Halbleiteranordnung gebildet wird. Es kann in einem weiteren Schritt vorgesehen sein, dass die Halbleiteranordnung von dem Substrat abgelöst wird.

Zum Bereitstellen der Halbleiteranordnung kann es auch vorgesehen sein, dass zunächst ein Substrat bereitgestellt wird, auf dem anschließend die Umverdrahtungslage hergestellt wird, die das biegbare Material und die mindestens eine Leiterbahn umfasst. Daraufhin kann der mindestens eine Halbleiterchip auf der Umverdrahtungslage angeordnet werden. Es kann vorgesehen sein, dass ein elektrischer Kontakt zwischen dem mindestens einen Halbleiterchip und der Umverdrahtungslage hergestellt wird. In einem weiteren Schritt kann der mindestens eine Halbleiterchip mit der Vergussmasse vergossen werden, so dass die Trägerstruktur gebildet wird, die die Vergussmasse und den darin eingebundenen mindestens einen Halbleiterchip umfasst, wobei aus der Trägerstruktur und der Umverdrahtungslage die Halbleiteranordnung gebildet wird. In einem weiteren Schritt kann es vorgesehen sein, dass die Halbleiteranordnung von dem Substrat abgelöst wird.

Die Erfindung betrifft außerdem ein elektronisches Bauelement, das mindestens drei entlang mindestens eines Trenngrabens vereinzelte Trägerelemente umfasst, die jeweils eine Vergussmasse umfassen. In mindestens eines der vereinzelten Trägerelemente ist mindestens ein Halbleiterchip eingebunden. Das elektronische Bauelement umfasst außerdem eine Umverdrahtungslage, die biegbares Material und mindestens eine Leiterbahn umfasst. Die vereinzelten Trägerelemente sind mit derselben Seite der Umverdrahtungslage verbunden, der mindestens eine Halbleiterchip ist mit der Umverdrahtungslage elektrisch leitfähig verbunden, mindestens drei benachbarte der vereinzelten Trägerelemente sind über die Umverdrahtungslage miteinander verbunden und die Umverdrahtungslage ist in einem Bereich eines der Trenngräben derart gebogen, dass mindestens zwei der vereinzelten Trägerelemente zumindest teilweise überlappend übereinander angeordnet sind. Außerdem ist die Umverdrahtungslage derart gebogen, dass mindestens zwei der vereinzelten Trägerelemente im Wesentlichen senkrecht zueinander angeordnet sind. Auf diese Weise kann eine besonders kompakte Bauform des elektronischen Bauelements erreicht werden.

Die Erfindung betrifft des Weiteren ein elektronisches Bauelement, welches mit dem oben beschriebenen Verfahren hergestellt wurde.

Ausführungsbeispiele der Erfindung werden nachfolgend anhand der Abbildungen beschrieben. Es zeigen
- Fig. 1(a)-(d): eine schematische Darstellung von Verfahrensschritten zur Herstellung einer Halbleiteranordnung,
- Fig. 2(a)-(d): eine schematische Darstellung von weiteren Verfahrensschritten zur Herstellung einer Halbleiteranordnung,
- Fig. 3: eine schematische Ansicht einer Halbleiteranordnung in Form eines rekonfigurierten Wafers,
- Fig. 4(a)-(d): verschiedene schematische Ansichten eines Pakets sowie ein elektronisches Bauelement,
- Fig. 5(a), (b): eine schematische Ansicht eines weiteren Pakets sowie ein weiteres elektronisches Bauelement,
- Fig. 6(a), (b): eine schematische Ansicht eines weiteren Pakets sowie ein weiteres elektronisches Bauelement,
- Fig. 7(a), (b): eine schematische Ansicht eines weiteren Pakets sowie ein weiteres elektronisches Bauelement und
- Fig. 8: eine schematische Ansicht eines elektronischen Bauelements und einer Kontur eines Gegenstandes.

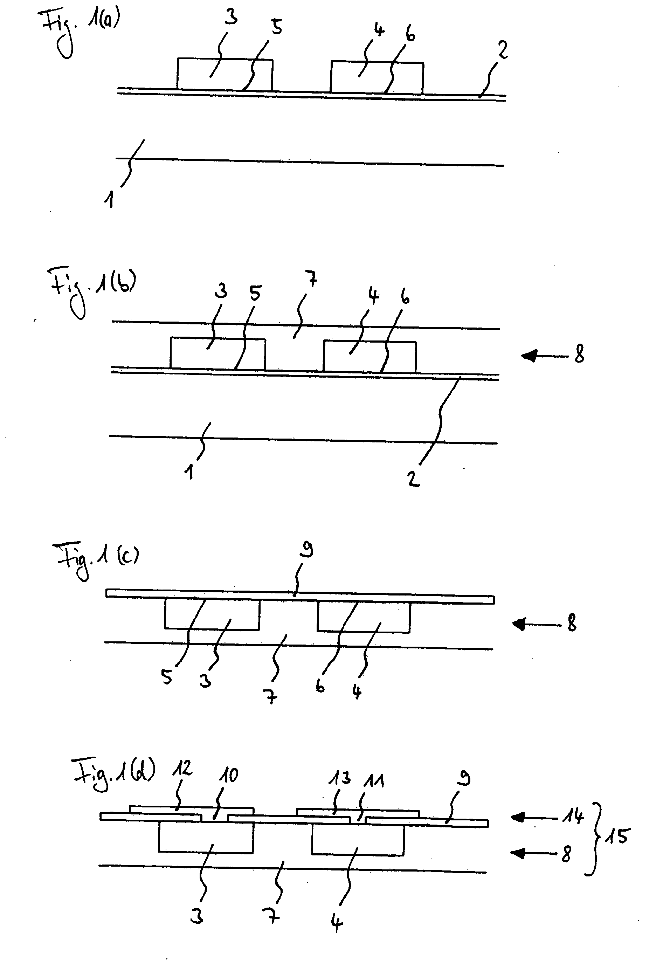

Fign. 1(a) bis 1(d) zeigen mehrere Ansichten eines Verfahrens zur Herstellung einer Halbleiteranordnung. In Fig. 1(a) sind ein Substrat 1 sowie eine darauf angeordnete wärmelösbare Folie 2 gezeigt. Zunächst werden auf dem Substrat 1 und der Folie 2 ein erster Halbleiterchip 3 und ein zweiter Halbleiterchip 4 nebeneinander angeordnet, wobei die Halbleiterchips 3,4 jeweils mit einer elektrisch aktiven Seite 5, 6 auf der Folie 2 aufliegen.

Die Halbleiterchips 3, 4 können beispielsweise aus einem oder mehreren Halbleiterwafern herausgesägt oder herausgespalten sein. Die Halbleiterchips 3, 4 können beispielsweise ein Chipsubstrat aus Silizium umfassen und integrierte Schaltkreise aufweisen. Auf der elektrisch aktiven Seite 5, 6 können Metallisierungen zur elektrischen Kontaktierung der integrierten Schaltkreise vorgesehen sein.

Anschließend werden die Halbleiterchips in eine Vergussmasse 7 eingegossen, wie in Fig. 1(b) gezeigt ist. Wiederkehrende Merkmale sind in dieser Abbildung und in den folgenden Abbildungen mit denselben Bezugszeichen versehen.

Die Vergussmasse kann beispielsweise Silikon und/oder Polyurethan, Polyimid und/oder Kunstharz, insbesondere Epoxidharz, umfassen. Nach dem Eingie-βen der Halbleiterchips 3, 4 in die Vergussmasse 7 härtet die Vergussmasse 7 aus, so dass die Vergussmasse 7 und die darin eingebetteten Halbleiterchips 3,4 eine Trägerstruktur 8 bilden.

Daraufhin wird die Trägerstruktur 8 unter Erhitzen der wärmelösbaren Folie 2 von der Folie 2 und dem Substrat 1 abgelöst. Anschließend wird die Trägerstruktur 8 umgedreht, so dass die elektrisch aktiven Seiten 5, 6 der Halbleiterchips 3, 4 nach oben zeigen. Daraufhin wird ein faltbares bzw. biegbares und elektrisch isolierendes Material 9 wie in Fig. 1(c) gezeigt ist auf die Trägerstruktur 8 aufgebracht. Das elektrisch isolierende Material 9 ist ein faltbares bzw. biegbares Polymer. Beispielsweise umfasst das elektrisch isolierende Material 9 Polyimid, Epoxidharz, Silikon und/oder Benzocyclobuten. Das elektrisch isolierende Material 9 bildet eine einfach zusammenhängende Schicht.

Anschließend werden Öffnungen 10, 11, beispielsweise in Form von Löchern oder Gräben, an den Stellen, an denen ein späterer elektrischer Kontakt zu den Halbleiterchips 3, 4 gewünscht ist, in das elektrisch isolierende Material 9 eingebracht. Die Öffnungen 10, 11 können beispielsweise durch bekannte Verfahren aus der Dünnfilmtechnologie wie Nass- oder Trockenätzprozesse und/oder unter Verwendung gängiger optischer Lithographieverfahren gebildet werden. Daraufhin erfolgt eine bereichsweise Metallisierung, beispielsweise mit Gold oder mit Kupfer, so dass Leiterbahnen 12, 13 gebildet werden, die die Halbleiterchips 3, 4 im Bereich der Öffnungen 10, 11 kontaktieren. Auch hierbei können beispielsweise gängige optische Lithographieverfahren zum Einsatz kommen. Die Leiterbahnen 12, 13 und das elektrisch isolierende Material 9 bilden eine Umverdrahtungslage 14. Die Umverdrahtungslage 14 und die mit der Umverdrahtungslage 14 verbundene Trägerstruktur 8 bilden eine Halbleiteranordnung 15.

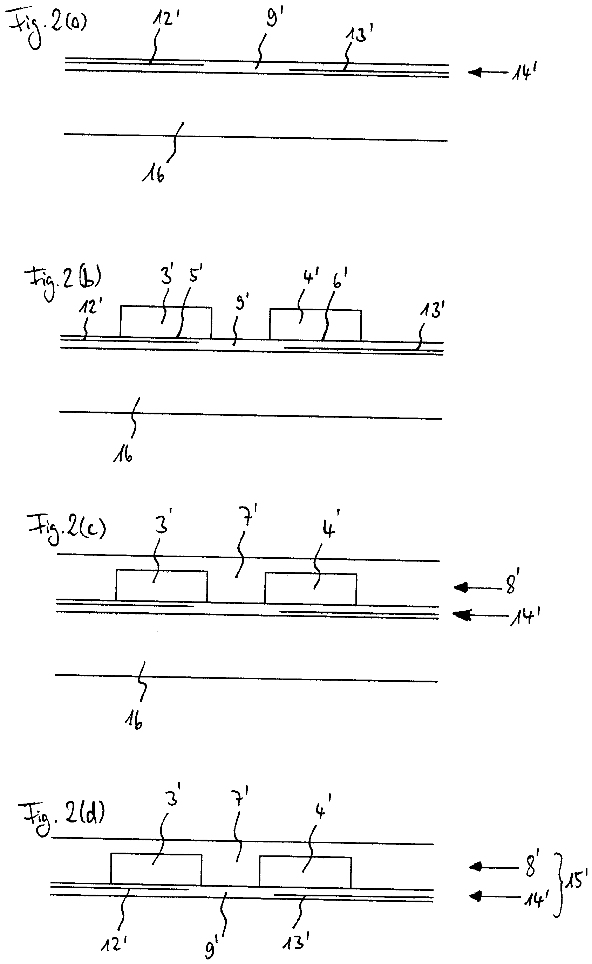

Fign. 2(a) bis 2(d) zeigen ein weiteres Verfahren zur Herstellung einer Halbleiteranordnung. In Fig. 2(a) ist ein weiteres Substrat 16 dargestellt. Das Substrat kann beispielsweise ein Glas-Substrat sein. Auf diesem Substrat wird zunächst eine Umverdrahtungslage 14' hergestellt, wobei die Umverdrahtungslage 14' elektrisch leitfähige Leiterbahnen 12', 13' und faltbares bzw. biegbares, elektrisch isolierendes Material 9' aufweist. Die Leiterbahnen 12', 13' sind in dem dargestellten Bereich der Umverdrahtungslage 14' in verschiedenen Lagen angeordnet.

Anschließend werden Halbleiterchips 3', 4' mit ihren elektrisch aktiven Seiten 5', 6' nebeneinander auf der Umverdrahtungslage 14' angeordnet, wie in Fig. 2(b) dargestellt ist. Wiederkehrende Merkmale sind in dieser Abbildung und in den folgenden Abbildungen wieder mit denselben Bezugszeichen versehen.

Beim Anordnen der Halbleiterchips 3', 4' auf der Umverdrahtungslage 14' oder nach dem Anordnen der Halbleiterchips 3', 4' auf der Umverdrahtungslage 14' werden elektrische Kontakte zwischen den elektrisch aktiven Seiten 5', 6' und der Umverdrahtungslage 14' hergestellt. Für die Herstellung dieser Kontakte können gängige Verfahren, wie beispielsweise Löten, Thermokompressionsbonden, Ultraschallbonden, Laserlöten oder ein Kleben mit einem leitfähigen Klebstoff, Verwendung finden. Nach dem Herstellen der elektrischen Kontakte kontaktieren die Leiterbahnen 12', 13' einen jeweiligen der Halbeiterchips 3', 4'.

Daraufhin werden die Halbleiterchips 3', 4' in eine Vergussmasse 7'eingegossen, die beispielsweise Silikon und/oder Polyurethan, Polyimid und/oder Kunstharz, insbesondere Epoxidharz, umfasst, so dass die Vergussmasse 7' die Halbleiterchips 3', 4' und die Umverdrahtungslage 14' vollständig bedeckt, wie in Fig. 2(c) gezeigt ist. Daraufhin härtet die Vergussmasse 14' aus. Die Vergussmasse 14' sowie die Halbleiterchips 3', 4' bilden eine Trägerstruktur 8'.

Anschließend werden die Trägerstruktur 8' und die Umverdrahtungslage 14' gemeinsam vom Substrat 16 abgelöst, so dass die in Fig. 2(d) gezeigte Halbleiteranordnung 15' erhalten wird.

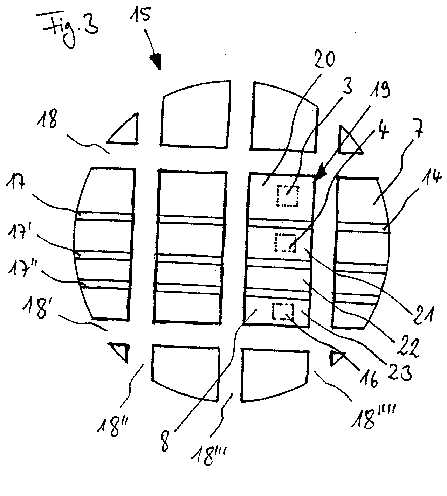

In Fig. 3 ist die Halbleiteranordnung 15 in einer schematischen Aufsicht dargestellt. Die Halbleiteranordnung 15 weist eine im Wesentlichen runde Form auf, die dem Umriss des hier nicht gezeigten Substrats 1 entspricht. Die Halbleiteranordnung 15 bildet einen rekonfigurierten Wafer, der die Vergussmasse 7 und die in die Vergussmasse 7 eingelassenen Halbleiterchips 3, 4 umfasst. Zusätzlich ist ein weiterer, in die Vergussmasse 7 eingelassener Halbleiterchip 16 gezeigt. Die Halbleiteranordnung 15 umfasst des Weiteren die Umverdrahtungslage 14.

In einer anderen Ausführung kann es vorgesehen sein, dass die Halbleiteranordnung 15 in einem eckigen Panelformat gefertigt wird.

Die Halbleiteranordnung 15 weist drei parallel verlaufende Trenngräben 17, 17', 17" auf, entlang derer die Trägerstruktur 8 getrennt wurde. Zum Trennen wurde die Halbleiteranordnung 15 in Richtung der Umverdrahtungslage 14 mittels Sägen ausgedünnt, so dass die Trenngräben 17, 17', 17" entstanden. Das Ausdünnen wurde abgebrochen, sobald die Umverdrahtungslage 14 erreicht wurde. Somit weisen die Trenngräben 17, 17', 17" eine Tiefe auf, welche der Dicke der Trägerstruktur 8 entspricht.

Die Halbleiteranordnung 15 weist zusätzlich Schnittlinien 18, 18', 18", 18''', 18'''' auf, entlang derer die Halbleiteranordnung 15 vollständig durchtrennt ist. Dadurch wird ein Paket 19 ausgebildet, welches vier im Bereich der Trenngräben 17, 17', 17" über die Umverdrahtungslage 14 verbundene vereinzelte Trägerelemente 20, 21, 22, 23 umfasst. In drei Trägerelemente 20, 21, 23 ist jeweils einer der Halbleiterchips 3, 4, 16 eingebettet.

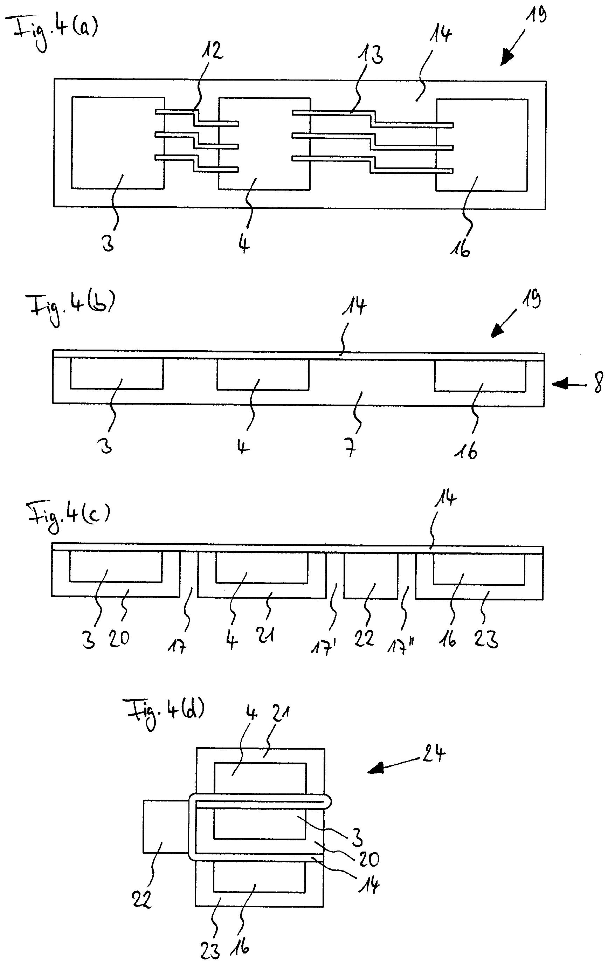

Fig. 4(a) zeigt eine schematische Aufsicht auf das Paket 19. Dargestellt ist die Umverdrahtungslage 14 mit Leiterbahnen, von denen zwei beispielhaft mit den Bezugszeichen 12 und 13 versehen sind. Zusätzlich sind die in dieser Ansicht hinter der Umverdrahtungslage 14 angeordneten Halbleiterchips 3, 4, 16 in Fig. 4(a) angedeutet.

In Fig. 4(b) ist schematisch eine Seitenansicht des Pakets 19 mit der Trägerstruktur 8 aus der Vergussmasse 7 und den Halbleiterchips 3, 4, 16 und mit der Umverdrahtungslage 14 gezeigt. Das Paket 19 wurde aus dem rekonfigurierten Wafer herausgetrennt. Trenngräben sind in diesem Beispiel nicht dargestellt. Fig. 4(c) zeigt dieselbe Ansicht nachdem die Trenngräben 17, 17', 17" hergestellt wurden, so dass das Paket 19 in vereinzelte Trägerelemente 20, 21, 22, 23 zerteilt ist, die über die im Bereich der Trenngräben 17, 17', 17" über die Umverdrahtungslage 14 miteinander verbunden sind.

Ein Abstand zwischen den Trenngräben mit den Bezugszeichen 17' und 17" ist hierbei derart gewählt, dass dieser einer Höhe der Trägerstruktur 8 und der Umverdrahtungslage 14 und somit einer Höhe jedes der vereinzelten Trägerelemente 20, 21, 22, 23 und der Umverdrahtungslage 14 entspricht.

Zum Herstellen eines elektronischen Bauelements 24 wird die Umverdrahtungslage 14 des in Fig. 4(c) dargestellten Pakets 19 im Bereich der Trenngräben 17, 17', 17" so gebogen, dass sich die vereinzelten Trägerelemente 20, 21, 22, 23 beim Biegen voneinander abwenden. Hierbei wird das Paket 19 zunächst im Bereich des Trenngrabens mit dem Bezugszeichen 17 so um 180 Grad gefaltet, dass das Trägerelement mit dem Bezugszeichen 21 oberhalb des Trägerelements mit dem Bezugszeichen 20 angeordnet wird. Anschließend wird das Paket 19 im Bereich des Trenngrabens mit dem Bezugszeichen 17' in einem rechten Winkel gebogen, so dass das Trägerelementelement mit dem Bezugszeichen 22 vertikal ausgerichtet ist. Schließlich wird das Paket 19 im Bereich des Trenngrabens mit dem Bezugszeichen 17" in einem rechten Winkel gebogen, so dass das Trägerelement mit dem Bezugszeichen 23 unterhalb des Trägerelements mit dem Bezugszeichen 20 angeordnet wird.

Die aus dem beschriebenen Biegen resultierende Anordnung ist in Fig. 4(d) dargestellt. Das gezeigte elektronische Bauelement 24 umfasst die vier vereinzelten Trägerelemente 20, 21, 22, 23. Die Trägerelemente mit den Bezugszeichen 20, 21, und 23 sind in dem gezeigten Beispiel vollständig überlappend übereinander angeordnet, während das Trägerelement mit dem Bezugszeichen 22 senkrecht zu den anderen Trägerelementen 20, 21, 23 angeordnet ist.

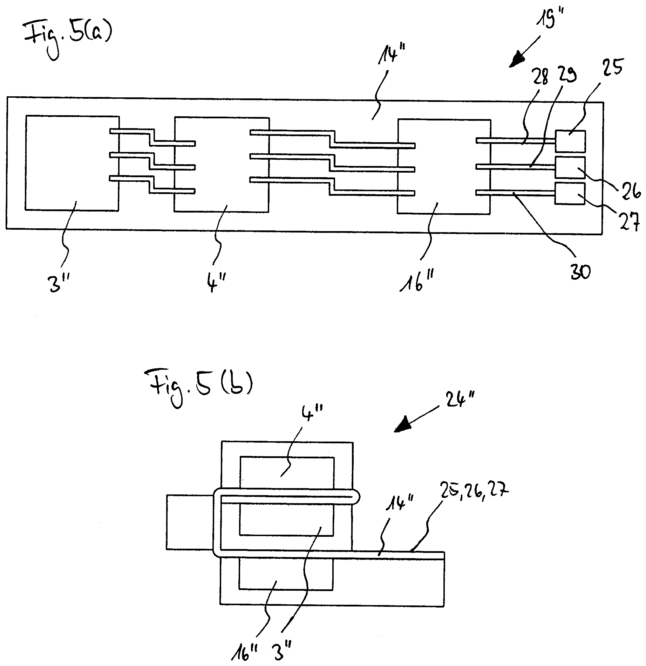

Ein weiteres Beispiel eines Pakets 19" ist in Fig. 5(a) dargestellt. Dieses Paket 19" unterscheidet sich von dem in der Fig. 4(a) dargestellten Paket 19 dadurch, dass die Umverdrahtungslage 14" Bond-Pads 25, 26, 27 aufweist. Die Bond-Pads 25, 26, 27 sind elektrisch leitfähig mit Leiterbahnen 28, 29, 30 verbunden, die wiederum mit zumindest einem von drei Halbleiterchips 3", 4", 16" elektrisch leitfähig verbunden sind.

In Fig. 5(b) ist ein aus dem Paket 19" durch Biegen gebildetes elektronisches Bauelement 24" gezeigt, welches beispielsweise durch Drahtbonden an die Bond-Pads 25, 26, 27 mit weiteren elektronischen Bauelementen oder mit einer Leiterplatte elektrisch verbunden werden kann.

Es ist auch möglich, dass das elektronische Bauelement 24" zusätzlich zu den Bond-Pads 25, 26, 27 oder anstatt der Bond-Pads 25, 26, 27 auf der Umverdrahtungslage 14" angeordnete und elektrisch leitfähig mit den Leiterbahnen 28, 29, 30 verbundene elektronische Komponenten, wie beispielsweise Widerstände, Kapazitäten oder Antennen, aufweist.

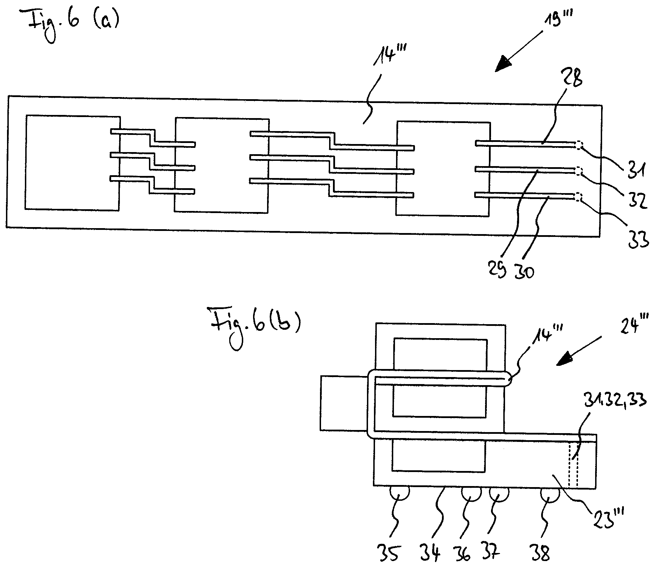

Eine weitere Ausführung des Pakets 19''' ist in Fig. 6(a) gezeigt. Dieses Paket 19''' unterscheidet sich von den oben genannten Paketen 19, 19" dadurch, dass seine Umverdrahtungslage 14''' drei elektrisch leitfähige Durchkontakte 31, 32, 33 aufweist, die elektrisch leitend mit jeweiligen der Leiterbahnen 28, 29, 30 verbunden sind. Die Durchkontakte 31, 32, 33 können mittels herkömmlicher Leiterplattentechnologie hergestellt werden.

Wie in Fig. 6(b) zu erkennen ist, erstrecken sich die Durchkontakte 31, 32, 33 in dem fertig gebogenen elektronischen Bauelement 24''' von der Umverdrahtungslage 14''' bis zu einer Rückseite 34 des mit der Bezugsziffer 23''' versehenen vereinzelten Trägerelements. Auf der Rückseite 34 des Trägerelements 23''' sind Lotkugeln 35, 36, 37, 38 angeordnet, die mit den Durchkontakten 31, 32, 33 elektrisch leitfähig verbunden sind. Die Lotkugeln 35, 36, 37, 38 sind eingerichtet, das elektronische Bauelement 24''' mit an einer Oberseite einer Leiterplatte vorgesehenen leitfähigen Regionen zu verbinden.

Es ist auch möglich, dass das elektronische Bauelement 24''' zusätzlich zu den Lotkugeln 35, 36, 37, 38 oder anstatt der Lotkugeln 35, 36, 37, 38 an der Rückseite 35 des Trägerelements 23''' elektrisch leitfähig mit den Druchkontakten 31, 32, 33 verbundene elektronische Komponenten, wie beispielsweise Widerstände, Kapazitäten oder Antennen, aufweist.

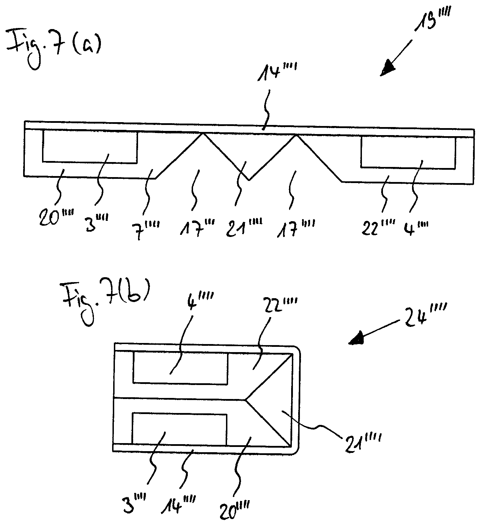

In Fig. 7(a) ist ein Paket 19'''' in einer weiteren Ausführungsform gezeigt. Dieses Paket 19'''' weist drei vereinzelte Trägerelemente 20"", 21'''', 22'''' auf, die in Bereichen von zwei Trenngräben 17''', 17'''' über eine Umverdrahtungslage 14'''' miteinander verbunden sind. Zwei vereinzelte Trägerelemente 20"", 22'''' umfassen in eine Vergussmasse 7'''' eingebettete Halbleiterchips 3"", 4"". Die Trenngräben 17''', 17'''' sind als sich in Richtung der Umverdrahtungslage 14'''' verjüngende V-Schnitte ausgeführt. Die V-Schnitte haben eine Form einer langgezogenen Aussparung, die in der Darstellung in einem der Umverdrahtungslage 14'''' zugewandten Bereich einen rechten Winkel aufweist.

Wie in Fig. 7(b) gezeigt ist, lässt sich das Paket 19'''' zu einem elektronischen Bauelement 24'''' biegen, indem die Umverdrahtungslage 14'''' im Bereich der Trenngräben 17''', 17'''' so gebogen wird, dass sich die vereinzelten Trägerelemente 20"", 21'''', 22'''' beim Biegen einander zuwenden. In der resultierenden Anordnung sind die vereinzelten Trägerelemente mit den Bezugszeichen 20'''' und 22'''' vollständig überlappend übereinander angeordnet. In dem gezeigten Beispiel sind die Trägerelemente mit den Bezugszeichen 20'''' und 22'''' parallel zueinander angeordnet. Es ist aber auch möglich, dass Pakete mit V-Schnitten hergestellt werden, deren Querschnitte im der Umverdrahtungslage 14'''' zugewandten Bereich einen stumpfen Winkel aufweisen, so dass die Trägerelemente mit den Bezugszeichen 20'''' und 22'''' nach dem Biegen in einem Winkel zueinander angeordnet sind. Auf diese Weise kann beispielsweise eine bevorzugte Ausrichtung eines gegebenenfalls in das Trägerelement mit dem Bezugszeichen 20""eingebetteten Sensors relativ zum Trägerelement mit dem Bezugszeichen 22'''' festgelegt werden.

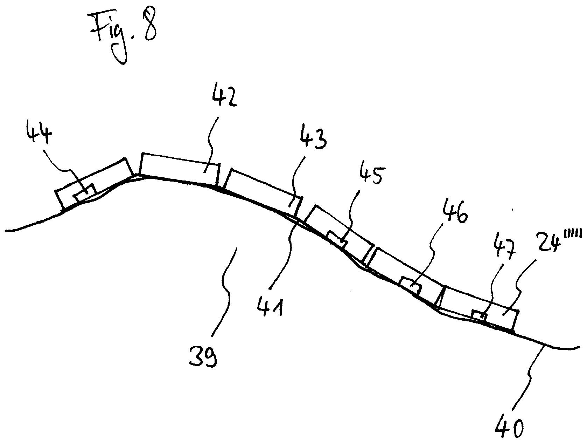

In Fig. 8 ist ein elektronisches Bauelement 24''''' dargestellt. Außerdem ist ein Gegenstand 39 dargestellt, dessen Oberfläche 40 einen gekrümmten Verlauf aufweist. Das elektronische Bauelement 24''''' umfasst eine biegbare Umverdrahtungslage 41, vereinzelte Trägerelemente, von denen zwei benachbarte beispielhaft mit den Bezugsziffern 42 und 43 gekennzeichnet sind, verschiedene Sensoren 44, 45 und weitere Halbleiterchips 46, 47. Die Umverdrahtungslage 41 ist an der Oberfläche 40 des Gegenstands 39 mit einem Klebstoff befestigt und derart gebogen, dass ein Verlauf der Umverdrahtungslage 41 in etwa dem Verlauf der Oberfläche 40 entspricht. Zwischen den vereinzelten Trägerelementen mit den Bezugszeichen 42 und 43 ist die Umverdrahtungslage 41 so gebogen, dass die Trägerelemente 42, 43 in einem Winkel von etwa 10 Grad zueinander angeordnet sind.

## Patentansprüche

1. Verfahren zum Herstellen eines elektronischen Bauelements (24) mit den Schritten:
- Bereitstellen einer Halbleiteranordnung (15) umfassend eine Trägerstruktur (8), die mindestens einen in eine Vergussmasse (7) eingebundenen Halbleiterchip (3, 4, 16) aufweist, und eine Umverdrahtungslage (14), die biegbares Material (9) und mindestens eine Leiterbahn (12, 13) aufweist, wobei die Trägerstruktur (8) zumindest bereichsweise mit der Umverdrahtungslage (14) verbunden ist und der mindestens eine Halbleiterchip (3, 4, 16) mit der Umverdrahtungslage (14) elektrisch leitfähig verbunden ist,
- Trennen der Trägerstruktur (8) entlang mindestens eines Trenngrabens (17, 17', 17", 17''', 17''''), derart, dass die Trägerstruktur (8) in mindestens zwei vereinzelte Trägerelemente (20, 21, 22, 23) aufgeteilt wird, wobei zwei benachbarte der vereinzelten Trägerelemente (20, 21, 22, 23) über den jeweiligen Trenngraben (17, 17', 17", 17''', 17'''') durch die Umverdrahtungslage (14) miteinander verbunden sind, wobei das Trennen der Trägerstruktur (8) durch mindestens einen in Richtung der Umverdrahtungslage (14) verjüngten V-Schnitt (17''', 17"") erfolgt.

2. Verfahren nach Anspruch 1, **gekennzeichnet durch** den Schritt:
- Biegen der Umverdrahtungslage (14) im Bereich eines Trenngrabens (17, 17', 17", 17''', 17"") um einen vorgegebenen Winkel.

3. Verfahren nach einem der Ansprüche 1 oder 2, **gekennzeichnet durch** den Schritt:
- Biegen der Umverdrahtungslage (14) im Bereich eines Trenngrabens (17, 17', 17", 17''', 17''''), derart, dass mindestens zwei der vereinzelten Trägerelemente (20, 21, 22, 23) zumindest teilweise überlappend übereinander angeordnet werden.

4. Verfahren nach einem der Ansprüche 1 bis 3, **gekennzeichnet durch** den Schritt:
- Falten der Umverdrahtungslage (14) am Bereich eines Trenngrabens (17, 17', 17", 17"', 17''''), derart, dass mindestens zwei benachbarte der vereinzelten Trägerelemente (20, 21, 22, 23) zumindest teilweise überlappend übereinander angeordnet werden, wobei das biegbare Material (9) ein faltbares Material (9) ist.

5. Verfahren nach einem der Ansprüche 1 bis 4, **dadurch gekennzeichnet, dass** das biegbare Material (9) ein biegbares Polymer umfasst.

6. Verfahren nach einem der Ansprüche 1 bis 5, **dadurch gekennzeichnet, dass** die Trägerstruktur (8) entlang mehrerer Trenngräben (17, 17', 17", 17''', 17'''') in mehrere vereinzelte Trägerelemente (20, 21, 22, 23) getrennt wird, die über die Umverdrahtungslage (14) miteinander verbunden sind, wobei die mehreren Trenngräben (17, 17', 17", 17''', 17"") im Wesentlichen parallel verlaufen.

7. Verfahren nach einem der Ansprüche 1 bis 6, **dadurch gekennzeichnet, dass** mindestens zwei benachbarte der Trenngräben (17', 17", 17''', 17'''') einen Abstand aufweisen, der im Wesentlichen einem Ein- oder Vielfachen einer Höhe der Trägerstruktur (8) und der Umverdrahtungslage (14) entspricht.

8. Verfahren nach einem der Ansprüche 1 bis 7, **gekennzeichnet durch** den Schritt:
- Herstellen eines Durchkontaktes (31, 32, 33) durch die Trägerstruktur (8), derart, dass eine elektrisch leitfähige Verbindung zwischen der Umverdrahtungslage (14) und einer von der Umverdrahtungslage (14) abgewandten Seite der Trägerstruktur (8) hergestellt wird.

9. Verfahren nach einem der Ansprüche 1 bis 8, **dadurch gekennzeichnet, dass** sich die zwei benachbarten der vereinzelten Trägerelemente (20, 21, 22, 23) beim Biegen voneinander abwenden.

10. Verfahren nach Anspruch 9, **dadurch gekennzeichnet, dass** sich die zwei benachbarten der vereinzelten Trägerelemente (20"", 21"", 22'''') beim Biegen einander zuwenden.

11. Verfahren nach einem der Ansprüche 1 bis 10, **dadurch gekennzeichnet, dass** das
- Bereitstellen der Halbleiteranordnung (15)
folgende Schritte umfasst:
- Bereitstellen des mindestens einen Halbleiterchips (3, 4, 16),
- Anordnen des mindestens einen Halbleiterchips (3, 4, 16) auf einem Substrat (1),
- Vergießen des mindestens einen Halbleiterchips (3, 4, 16), so dass die Trägerstruktur (8) gebildet wird, die die Vergussmasse (7) und den darin eingebundenen mindestens einen Halbleiterchip (3, 4, 16) umfasst,
- Herstellen der zumindest bereichsweise mit der Trägerstruktur (8) verbundenen Umverdrahtungslage (14), die das biegbare Material (9) und die mindestens eine Leiterbahn (12, 13) umfasst, derart, dass die Umverdrahtungslage (14) den mindestens einen Halbleiterchip (3, 4, 16) elektrisch kontaktiert, wobei aus der Trägerstruktur (8) und der Umverdrahtungslage (14) die Halbleiteranordnung (15) gebildet wird,
- Ablösen der Halbleiteranordnung (15) von dem Substrat (1).

12. Verfahren nach einem der Ansprüche 1 bis 10, **dadurch gekennzeichnet, dass** das
- Bereitstellen der Halbleiteranordnung (15)
folgende Schritte umfasst:
- Bereitstellen eines Substrats (16),
- Herstellen der Umverdrahtungslage (14), die das biegbare Material (9) und die mindestens eine Leiterbahn (12, 13) umfasst, auf dem Substrat (16),
- Anordnen des mindestens einen Halbleiterchips (3, 4, 16) auf der Umverdrahtungslage (14),
- Herstellen eines elektrischen Kontakts zwischen dem mindestens einen Halbleiterchip (3, 4, 16) und der Umverdrahtungslage (14),
- Vergießen des mindestens einen Halbleiterchips (3, 4, 16) mit der Vergussmasse (7), so dass die Trägerstruktur (8) gebildet wird, die die Vergussmasse (7) und den darin eingebundenen mindestens einen Halbleiterchip (3, 4, 16) umfasst, wobei aus der Trägerstruktur (8) und der Umverdrahtungslage (14) die Halbleiteranordnung (15) gebildet wird,
- Ablösen der Halbleiteranordnung (15) von dem Substrat (16).

13. Elektronisches Bauelement (24), umfassend zumindest zwei entlang mindestens eines Trenngrabens (17"', 17"") vereinzelte Trägerelemente (20"", 21"", 22""), die jeweils eine Vergussmasse (7"") umfassen, wobei in mindestens eines der vereinzelten Trägerelemente (20'''', 21"", 22"") mindestens ein Halbleiterchip (3"", 4"") eingebunden ist, und weiterhin umfassend eine Umverdrahtungslage (14), die biegbares Material (9) und mindestens eine Leiterbahn (12, 13) aufweist,
wobei die vereinzelten Trägerelemente (20'''', 21"", 22"") mit derselben Seite der Umverdrahtungslage (14) verbunden sind und der mindestens eine Halbleiterchip (3"", 4"") mit der Umverdrahtungslage (14) elektrisch leitfähig verbunden ist,
wobei zwei benachbarte der vereinzelten Trägerelemente (20'''', 21"", 22"") über den Trenngraben (17''', 17"") durch die Umverdrahtungslage (14) miteinander verbunden sind,
wobei der Trenngraben (17''', 17'''') durch einen in Richtung der Umverdrahtungslage (14) verjüngten V-Schnitt (17''', 17'''') gebildet ist.

## Claims

1. A method for producing an electronic component (24), comprising the following steps:
- providing a semiconductor array (15) comprising a carrier structure (8) including at least one semiconductor chip (3, 4, 16) incorporated into a potting compound (7), a redistribution layer (14) including flexible material (9) and at least one strip conductor (12, 13), wherein the carrier structure (8), at least in regions, is connected to the redistribution layer (14), and the at least one semiconductor chip (3, 4, 16) is electrically conductively connected to the redistribution layer (14); and
- separating the carrier structure (8) along at least one trench (17, 17', 17", 17''', 17"") in such a manner that the carrier structure (8) is divided into at least two diced carrier elements (20, 21, 22, 23), wherein two adjacent carrier elements of the diced carrier elements (20, 21, 22, 23) are connected to one another via the respective trench (17, 17', 17", 17''', 17"") by way of the redistribution layer (14), wherein the separating of the carrier structure (8) is carried out by at least one V-cut (17''', 17"") that is tapered in the direction of the redistribution layer (14).

2. The method according to claim 1, **characterized by** the following step:
- bending the redistribution layer (14) by a predefined angle in the region of a trench (17, 17', 17", 17''', 17"").

3. The method according to any one of claim 1 or 2, **characterized by** the following step::
- bending the redistribution layer (14) in the region of a trench (17, 17', 17", 17''', 17"") in such a way that at least two of the diced carrier elements (20, 21, 22, 23) are arranged so as to at least partly overlap one another.

4. A method according to any one of claims 1 to 3, **characterized by** the following step:
- folding the redistribution layer (14) at the region of a trench (17, 17', 17", 17''', 17"") in such a way that at least two adjacent carrier elements of the diced carrier elements (20, 21, 22, 23) are arranged so as to at least partly overlap one another, wherein the flexible material (9) is a foldable material (9).

5. A method according to any one of claims 1 to 4, **characterized in that** the flexible material (9) comprises a flexible polymer.

6. A method according to any one of claims 1 to 5, **characterized in that** the carrier structure (8) is separated along several trenches (17, 17', 17", 17''', 17"") into several diced carrier elements (20, 21, 22, 23) which are connected to one another via the redistribution layer (14), the several trenches (17, 17', 17", 17''', 17"") extending essentially in parallel.

7. A method according to any one of claims 1 to 6, **characterized in that** at least two adjacent trenches of the trenches (17', 17", 17''', 17'''') have a distance which essentially corresponds to one time or several times a height of the carrier structure (8) and of the redistribution layer (14).

8. A method according to any one of claims 1 to 7, **characterized by** the following step:
- creating a plated through-hole (31, 32, 33) through the carrier structure (8) in such a way that an electrically conductive connection is established between the redistribution layer (14) and a side of the carrier structure (8) which faces away from the redistribution layer (14).

9. A method according to any one of claims 1 to 8, **characterized in that** the two adjacent of the diced carrier elements (20, 21, 22, 23) turn away from one another on bending.

10. The method according to claim 9, **characterized in that** the two adjacent of the diced carrier elements (20'''', 21'''', 22'''') turn toward one another on bending.

11. A method according to any one of claims 1 to 10, **characterized in that**
- the providing of the semiconductor array (15) comprises the following steps:
- providing the at least one semiconductor chip (3, 4, 16);
- arranging the at least one semiconductor chip (3, 4, 16) on a substrate (1);
- potting the at least one semiconductor chip (3, 4, 16) so that the carrier structure (8) comprising the potting compound (7) and the at least one semiconductor chip (3, 4, 16) incorporated therein is formed,
- producing the redistribution layer (14), which, at least in regions, is connected to the carrier structure (8) and which includes the flexible material (9) and the at least one strip conductor (12, 13), in such a way that the redistribution layer (14) electrically contacts the at least one semiconductor chip (3, 4, 16), wherein the semiconductor array (15) is formed from the carrier structure (8) and the redistribution layer (14) and
- detaching the semiconductor array (15) from the substrate (1).

12. A method according to any one of claims 1 to 10, **characterized in that**
- the providing of the semiconductor array (15) comprises the following steps:
- providing a substrate (16);
- producing the redistribution layer (14), comprising the flexible material (9) and the at least one strip conductor (12, 13), on the substrate (16);
- arranging the at least one semiconductor chip (3, 4, 16) on the redistribution layer (14);
- establishing an electrical contact between the at least one semiconductor chip (3, 4, 16) and the redistribution layer (14);
- potting the at least one semiconductor chip (3, 4, 16) with the potting compound (7), so that the carrier structure (8) comprising the potting compound (7) and the at least one semiconductor chip (3, 4, 16) incorporated therein is formed, wherein the semiconductor array (15) is formed from the carrier structure (8) and the redistribution layer (14), and
- detaching the semiconductor array (15) from the substrate (16).

13. An electronic component (24), comprising:
at least two carrier elements (20'''', 21'''', 22"") diced along at least one trench (17''', 17""), which each comprise a potting compound (7""), wherein at least one semiconductor chip (3'''', 4'''') is integrated into at least one of the diced carrier elements (20'''', 21'''', 22""), and furthermore comprising a redistribution layer (14) including flexible material (9) and at least one strip conductor (12, 13),
the diced carrier elements (20'''', 21"", 22"") being connected to the same side of the redistribution layer (14), and the at least one semiconductor chip (3"", 4"") being electrically conductively connected to the redistribution layer (14),
two adjacent of the diced carrier elements (20'''', 21'''', 22'''') being connected to one another via the trench (17''', 17"") by way of the redistribution layer (14),
the trench (17''', 17"") being formed by a V-cut (17''', 17"") that is tapered in the direction of the redistribution layer (14).

## Revendications

1. Procédé de fabrication d'un composant électronique (24) comprenant les étapes de :
- fourniture d'un ensemble semi-conducteur (15) comprenant une structure support (8), qui présente au moins une puce semi-conductrice (3, 4, 16) incorporée dans une matière de remplissage (7), et une couche de câblage (14), qui présente une matière flexible (9) et au moins une piste conductrice (12, 13), où la structure support (8) est reliée au moins par endroits avec la couche de câblage (14) et l'au moins une puce semi-conductrice (3, 4, 16) est reliée avec la couche de câblage (14) de manière conductrice électriquement,
- séparation de la structure support (8) le long d'au moins une tranchée de séparation (17, 17', 17", 17''', 17""), de telle manière que la structure support (8) est divisée en au moins deux éléments supports (20, 21, 22, 23) individuels, où deux éléments voisins des éléments supports (20, 21, 22, 23) individuels sont reliés l'un à l'autre par la couche de câblage (14) par le biais de la tranchée de séparation (17, 17', 17", 17''', 17"") respective, où la séparation de la structure support (8) a lieu par une découpe en V (17''', 17"") s'amenuisant en direction de la couche de câblage (14).

2. Procédé selon la revendication 1, **caractérisé par** l'étape :
- de pliage de la couche de câblage (14) dans la zone d'une tranchée de séparation (17, 17', 17", 17''', 17"") avec un angle prédéfini.

3. Procédé selon l'une des revendications 1 ou 2, **caractérisé par** l'étape :
- de pliage de la couche de câblage (14) dans la zone d'une tranchée de séparation (17, 17', 17", 17''', 17""), de telle manière qu'au moins deux éléments des éléments supports (20, 21, 22, 23) individuels sont disposés l'un sur l'autre en se superposant au moins partiellement.

4. Procédé selon l'une des revendications 1 à 3, **caractérisé par** l'étape :
- de repliage de la couche de câblage (14) dans la zone d'une tranchée de séparation (17, 17', 17", 17''', 17""), de telle manière qu'au moins deux éléments voisins des éléments supports (20, 21, 22, 23) individuels sont disposés l'un sur l'autre en se superposant au moins partiellement, où la matière flexible (9) est une matière (9) pouvant être pliée.

5. Procédé selon l'une des revendications 1 à 4, **caractérisé en ce que** la matière flexible (9) comprend un polymère flexible.

6. Procédé selon l'une des revendications 1 à 5, **caractérisé en ce que** la structure support (8) est séparée en plusieurs éléments supports (20, 21, 22, 23) individuels le long de plusieurs tranchées de séparation (17, 17', 17", 17''', 17""), qui sont reliés les uns aux autres par le biais de la couche de câblage (14), où les nombreuses tranchées de séparation (17, 17', 17", 17''', 17"") s'étendent essentiellement de manière parallèle.

7. Procédé selon l'une des revendications 1 à 6, **caractérisé en ce qu'**au moins deux tranchées voisines des tranchées de séparation (17', 17", 17''', 17"") présentent un intervalle qui correspond essentiellement à une hauteur ou à un multiple d'une hauteur de la structure support (8) et de la couche de câblage (14).

8. Procédé selon l'une des revendications 1 à 7, **caractérisé par** l'étape :
- de fabrication d'un contact traversant (31, 32, 33) à travers la structure support (8), de telle manière qu'une connexion électriquement conductrice est réalisée entre la couche de câblage (14) et une face de la structure support (8) opposée à la couche de câblage (14).

9. Procédé selon l'une des revendications 1 à 8, **caractérisé en ce que** les deux éléments voisins des éléments supports (20, 21, 22, 23) individuels s'opposent l'un à l'autre lors du pliage.

10. Procédé selon la revendication 9, **caractérisé en ce que** les deux éléments voisins des éléments supports (20'''', 21'''', 22"") individuels se font face lors du pliage.

11. Procédé selon l'une des revendications 1 à 10, **caractérisé en ce que**
- la fourniture de l'ensemble semi-conducteur (15) comprend les étapes suivantes :
- fourniture de l'au moins une puce semi-conductrice (3, 4, 16),
- disposition de l'au moins une puce semi-conductrice (3, 4, 16) sur un substrat (1),
- coulage de l'au moins une puce semi-conductrice (3, 4, 16), de sorte que la structure support (8), qui comprend la matière de remplissage (7) et l'au moins une puce semi-conductrice (3, 4, 16) y étant incorporée, est formée,
- fabrication de la couche de câblage (14), reliée au moins par endroits avec la structure support (8) et qui comprend la matière flexible (9) et l'au moins une piste conductrice (12, 13) de telle manière que la couche de câblage (14) est en contact de manière électrique avec l'au moins une puce semi-conductrice (3, 4, 16), où un ensemble semi-conducteur (15) est formé à partir de la structure support (8) et de la couche de câblage (14),
- détachement de l'ensemble semi-conducteur (15) du substrat (1).

12. Procédé selon l'une des revendications 1 à 10, **caractérisé en ce que**
- fourniture de l'ensemble semi-conducteur (15) comprend les étapes suivantes :
- fourniture d'un substrat (16),
- fabrication de la couche de câblage (14), qui comprend la matière flexible (9) et l'au moins une piste conductrice (12, 13), sur le substrat (16),
- disposition de l'au moins une puce semi-conductrice (3, 4, 16) sur la couche de câblage (14),
- établissement d'un contact électrique entre l'au moins une puce semi-conductrice (3, 4, 16) et la couche de câblage (14),
- coulage de l'au moins une puce semi-conductrices (3, 4, 16) avec la matière de remplissage (7), de sorte que la structure support (8), qui comprend la matière de remplissage (7) et l'au moins une puce semi-conductrice (3, 4, 16) y étant incorporée, est formée, où l'ensemble semi-conducteur (15) est formé à partir de la structure support (8) et de la couche de câblage (14),
- détachement de l'ensemble semi-conducteur (15) du substrat (16).

13. Composant électronique (24), comprenant
au moins deux éléments supports (20"", 21"", 22"") individuels, qui comprennent respectivement une matière de remplissage (7""), le long d'au moins une tranchée de séparation (17''', 17""), où au moins une puce semi-conductrice (3"", 4"") est incorporée dans au moins un des éléments supports (20"", 21"", 22"") individuels et comprenant en outre une couche de câblage (14), qui présente une matière flexible (9) et au moins une piste conductrice (12, 13),
dans lequel les éléments supports (20"", 21"", 22"") individuels sont reliés avec la même face de la couche de câblage (14) et l'au moins une puce semi-conductrice (3"", 4"") est reliée de manière conductrice électriquement avec la couche de câblage (14),
dans lequel deux éléments voisins des éléments supports (20"", 21"", 22"") individuels sont reliés l'un à l'autre par la couche de câblage (14) par le biais des tranchées de séparation (17''', 17""),
dans lequel la tranchée de séparation (17''', 17"") est formée par une découpe en V (17''', 17"") s'amenuisant en direction de la couche de câblage (14).
